# EUROPEAN PATENT APPLICATION

(11) **EP 2 500 092 A1**
(43) Date of publication of application: **19.09.2012**
(21) Application number: 10825091.1
(22) Date of filing: 22.10.2010
(51) Int. Cl.: B01J 23/89, B01D 53/94, B01J 37/02, C23C 14/06, F01N 3/10

(54) **CATALYST FOR NOX REMOVAL**

(30) Priority: 23.10.2009 JP 2009244704
(71) Applicant: Toyota Jidosha Kabushiki Kaisha, Toyota-shi, Aichi 471-8571 (JP)
(72) Inventor: OSAKI, Mayuko, Toyota-shi Aichi 471-8571 (JP); HIRATA, Hirohito, Toyota-shi Aichi 471-8571 (JP); NAGATA, Naoto, Toyota-shi Aichi 471-8571 (JP); MATSUMOTO, Yuji, Yokohama-shi Kanagawa 226-8503 (JP); KURAMOTO, Kei, Aichi-gun Aichi 480-1192 (JP)
(74) Representative: Duckworth, Timothy John
(86) International application number: PCT/JP2010/069232
(87) International publication number: WO 2011/049245

(57) **Abstract**

The present invention relates to a catalyst for purification of nitrogen oxides, the catalyst comprising a solid in which Au and Fe atoms exist in a state of being close. In accordance with the present invention, a catalyst that can demonstrate NO_{X} purification performance at low temperatures and/or in an oxidative atmosphere is provided.

## Description

### Technical Field

The present invention relates to catalysts for purification of nitrogen oxides (hereinafter may also be abbreviated as NO_{X}) and more particularly relates to a novel catalyst for purification of NO_{X}, the catalyst comprising a solid in which Au and Fe atoms exist in a state of being close and which enables the purification of NO_{X} at low temperatures and/or in an oxidative atmosphere.

### Background Art

In recent years, regulations on exhaust gases have been strengthened worldwide year by year from the viewpoint of global environmental protection. As a measure against them, an exhaust gas purification catalyst is used in an internal combustion engine. In the exhaust gas purification catalyst, a noble metal such as Pt, Pd, or Rh has been used as a catalyst component in order to efficiently remove HC, CO, and NO_{X} from exhaust gases.
In an automobile using a catalyst for purification, such as a gasoline engine or a diesel engine, various systems have been used for improving catalytic activity and fuel efficiency. For example, combustion has been performed on the condition that an air-fuel ratio (A/F) is lean (excess oxygen) during a steady operation in order to improve the fuel efficiency while combustion has temporarily been performed on the condition that it is stoichiometric (theoretical air-fuel ratio, A/F = 14.7) to rich (excess fuel) in order to improve the catalytic activity.

However, noble metal catalysts such as Pt, Pd, and Rh known in the art have low NO_{X} purification performance on low-temperature and oxidization conditions and it is necessary to make the catalyst for purification have high temperature and to add HC (hydrocarbon), CO, or the like to make a reducing atmosphere in order to enhance the purification performance. An air-fuel ratio (A/F) cannot be increased even during a steady operation due to the influence on the catalytic activity, so that the noble metal catalysts provide limited improvement in fuel efficiency.
As described above, in the noble metal catalysts known in the art, energy for making the catalyst for purification have high temperature, fuel for temporarily making the catalyst for purification in a reducing atmosphere, and a reduced air-fuel ratio (A/F) in an engine are needed for obtaining purification performance, so that a new catalyst for purification that can exhibit NO_{X} purification performance at low temperatures and/or in an oxidative atmosphere has been demanded for improving the fuel efficiency of internal combustion engines including automotive engines.
On the other hand, all the noble metal catalysts have the problem of exhaustion of resources, so that a catalyst using another metal, having purification performance equivalent to or better than those of the conventional noble metal catalysts, or a purification catalyst that can be prepared by a reduced amount of the noble metals used has been demanded.
Therefore, various attempts of improvement of catalysts for purification have been made.

For example, Japanese Unexamined Patent Application Publication No. 8-257403 describes an exhaust gas purification catalyst with high thermal resistance and excellent NO_{X} purification performance, which is composed of a composite oxide comprising at least one of transition metal atoms and at least one element of Al and Si and has a part of a surface formed with the transition metal.
In addition, Patent No. 3760717 describes a low-temperature harmful gas purification catalyst in which the ultrafine particles of at least one metal selected from the group consisting of Pt, Pd, Rh, Ru, Ir, Os, Au, Ag, Cu, Fe, and Ni are carried on the carrier of a metal oxide or a carbonaceous material using a high-temperature high-pressure fluid. In the above-described publication, the purification catalyst in which one of Pt, Pd, Rh, Ru, Fe, Ni, and Au is carried by a high-temperature high-pressure method or a supercritical method is described as a specific example.

Furthermore, Japanese Unexamined Patent Application Publication No. 2003-190787 describes a catalyst for purification of engine exhaust gases in which one or two or more selected from the group consisting of gold, silver, iron, zinc, manganese, cerium, and platinum group elements are carried on 12Cao·7Al₂O₃ which is a principal component. As a specific example, the catalyst for purification in which gold, silver, platinum, palladium, copper, iron, zinc, manganese, cerium, or rhodium alone or two of silver and rhodium, ruthenium, or copper are carried on 12Cao·7Al₂O₃ which is the principal component is exhibited to demonstrate the effect of reducing a combustion temperature by oxidation reaction of a particulate matter (PM) by oxygen radicals. However, the above-described publication does not specify the positional relationship between the two metals.

### Citation List

### Patent Literature

Patent Literature 1:
   Japanese Unexamined Patent Application Publication No. 8-257403
Patent Literature 2:
   Patent No. 3760717
Patent Literature 3:
   Japanese Unexamined Patent Application Publication No. 2003-190787

### Summary of Invention

### Technical Problem

However, these known catalysts for purification do not demonstrate NO_{X} purification performance at low temperatures and in an oxidative atmosphere.
Thus, an object of the present invention is to provide a catalyst that can demonstrate NO_{X} purification performance at low temperatures and/or in an oxidative atmosphere.

### Solution to Problem

As a result of extensive research for the purpose of achieving the object, the present inventors found that the reaction of decomposition of NO_{X} is dissociative adsorption of NO_{X} → desorption of N₂ and O₂ and a material having a low O₂ desorption temperature has high NO_{X} purification performance and, as a result of further examination, the present invention was accomplished.
The present invention relates to a catalyst for purification of nitrogen oxides, the catalyst comprising a solid in which Au and Fe atoms exist in a state of being close.

### Advantageous Effect of the Invention

In accordance with the present invention, a catalyst that can demonstrate NO_{X} purification performance at low temperatures and/or in an oxidative atmosphere can be obtained.

### Brief Description of Drawings

[Figure 1] Figure 1 is a schematic view of catalysts for purification of NO_{X} according to embodiments of the present invention.
[Figure 2] Figure 2 is a graph indicating the NO decomposition and desorption characteristics of the catalysts for purification in Examples of the present invention and the catalysts for purification in Comparative Examples in a NO gas atmosphere (oxidative atmosphere).
[Figure 3] Figure 3 is a graph indicating the relationships between a surface Fe concentration and a NO dissociative adsorption or desorption temperature of the catalysts for purification (represented by AuFe) in Examples of the present invention by AES (Auger Electron Spectroscopy).
[Figure 4] Figure 4 is the secondary electron images of the surface of a Au thin film deposited on an Al₂O₃ (sapphire) substrate and Au particle surfaces by AES.
[Figure 5] Figure 5 is a schematic view of a PLD (Pulsed Laser Deposition) apparatus used in Examples of the present invention.
[Figure 6] Figure 6 is a secondary electron image obtained by measuring a thin film after deposition of Fe in the catalyst for purification in accordance with Example of the present invention by SEM.
[Figure 7] Figure 7 is a secondary electron image obtained by measuring the thin film after the deposition of Fe and heat treatment at 350°C in the catalyst for purification in accordance with Example of the present invention by SEM.
[Figure 8-1] Figure 8-1 illustrates N1s XPS spectra indicating the energy peaks of the catalyst for purification in accordance with Example of the present invention in the NO gas atmosphere (oxidative atmosphere) at room temperature.
[Figure 8-2] Figure 8-2 illustrates Fe2p XPS spectra indicating the energy peaks of the catalyst for purification in accordance with Example of the present invention in the NO gas atmosphere (oxidative atmosphere).
[Figure 9-1] Figure 9-1 is a graph indicating a relationship between heating temperatures and O AES peak intensities after adsorption of NO in the catalyst for purification in accordance with Example of the present invention.
[Figure 9-2] Figure 9-2 is a graph indicating a relationship between heating temperatures and N AES peak intensities after the adsorption of NO in the catalyst for purification in accordance with Example of the present invention.
[Figure 10] Figure 10 illustrates views of XRD measurement of the catalyst for purification in Example of the present invention after the deposition of Fe and after the heating.
[Figure 11-1] Figure 11-1 is a graph indicating a relationship between heating temperatures and O AES peak intensities after adsorption of NO to Fe deposited on an Al₂O₃ substrate by a PLD apparatus.
[Figure 11-2] Figure 11-2 is a graph indicating a relationship between heating temperatures and N AES peak intensities after the adsorption of NO to Fe deposited on the Al₂O₃ substrate by the PLD apparatus.
[Figure 12-1] Figure 12-1 illustrates N1s XPS spectra in a temperature rising process after adsorption of 1 L of NO with Rh in Comparative Example.
[Figure 12-2] Figure 12-2 illustrates O1s XPS spectra in the temperature rising process after the adsorption of 1 L of NO with Rh in Comparative Example.
[Figure 13-1] Figure 13-1 is the N1s XPS spectrum of Au under circulation of NO at each temperature.
[Figure 13-2] Figure 13-2 is the Au4f XPS spectrum of Au under the circulation of NO at each temperature.
[Figure 14] Figure 14 is a graph indicating relationships between heating temperatures and the concentrations of both elements (Au and Fe) in a surface in the catalyst for purification in Example of the present invention.
[Figure 15] Figure 15 is a graph indicating NO decomposition and desorption characteristics in each catalyst material in accordance with Examples and Comparative Examples of the present invention.
[Figure 16] Figure 16 is a schematic view indicating an example of the state in which Au and Fe atoms are close in a solid.
[Figure 17] Figure 17 is a Au-Fe phase diagram (calculated) cited and copied from Binary Alloy Phase Diagram Vol.2 p.259 1984.

### Description of Embodiments

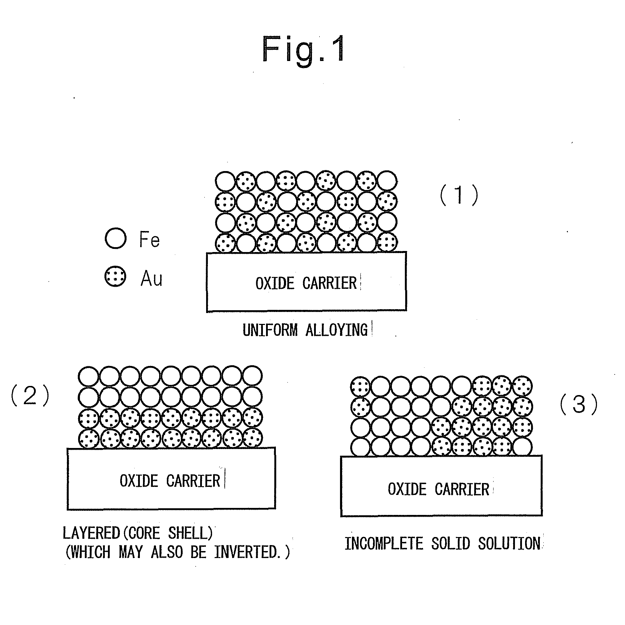

In the catalyst for purification of NO_{X} according to the present invention, Au and Fe atoms preferably exist in a state of being close in a solid.
The state in which the Au and Fe atoms are close in the solid refers to the inclusion in which at least one of first atoms in contact with second atoms of the Au and Fe atoms is in the state of being close in the state of existing in nanoparticles which are primary particles or in a thin film.
Embodiments of the present invention will be explained in detail below with reference to the drawings.
The catalyst for purification of NO_{X} according to the present invention may be in the state of being close in complete solid solution (alloying) in which Au and Fe atoms are homogeneously dispersed on a carrier such as an oxide carrier, for example, as illustrated in Figure 1 (1), may be in the state in which Fe atoms are layered on a thin film in which Au atoms are layered on an oxide carrier and the Au and Fe atoms are close in a layered plane as illustrated in Figure 1 (2) (or the configuration may also be inverted), or may be in the state of being incomplete solid solution in which Au and Fe atoms are each layered in partial regions on an oxide carrier and the Au and Fe atoms are close in their borders as illustrated in Figure 1 (3). Even in the case of the configuration as illustrated in Figure 1 (2), at least the solid solution (alloying) of both elements which are close is considered to proceed by heating. In the case of particles, they may also have a core shell structure.

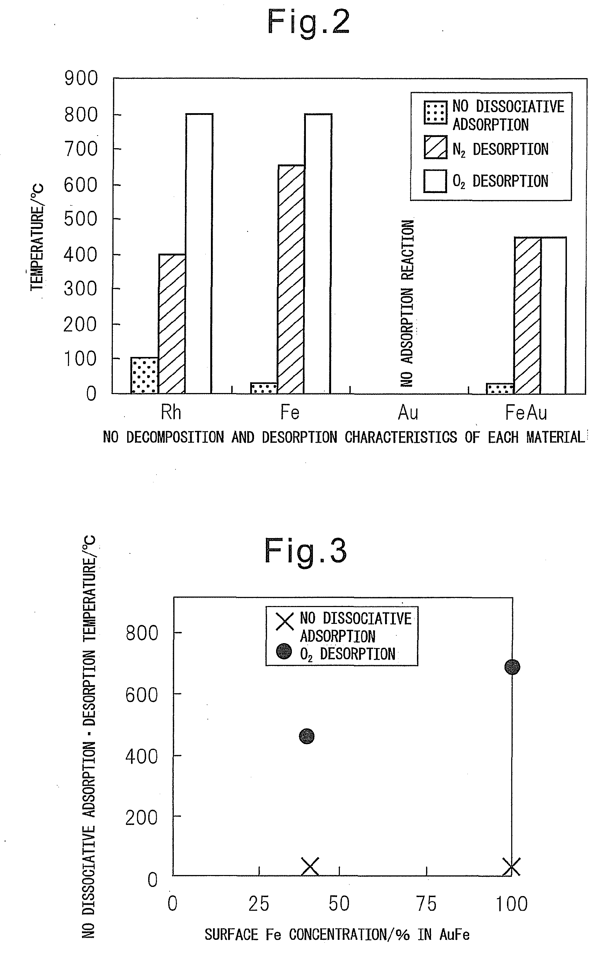

Referring to Figure 2, in the NO gas atmosphere under the circulation of NO (oxidative atmosphere: lean condition), any NO adsorption reaction does not occur in Au alone, the dissociative adsorption of NO at about 100°C, the desorption of N₂ at about 400°C, and the desorption of O₂ at 800°C occur in Rh, and the dissociative adsorption of NO at about 40°C, the desorption of N₂ at about 660°C, and the desorption of O₂ at 800°C occur in Fe, whereas the dissociative adsorption of NO at about 40°C, the desorption of N₂ at about 450°C, and the desorption of O₂ at about 450°C occur in the catalyst (represented by FeAu) according to an embodiment of the present invention. As described above, in accordance with the catalyst for purification of NO_{X} according to an embodiment of the present invention, the NO_{X} purification performance was found to be able to be produced at a low temperature of about 450°C and in an oxidative atmosphere.

This indicates that the decomposition reaction of NO is dissociative adsorption of NO → desorption of N₂ and O₂ and a material that adsorbs NO and has a low O₂ desorption temperature has high purification performance.
No or difficult desorption of O₂ has been a factor of lowering the activity of a purification catalyst, NO has not been able to be purified in an oxidative atmosphere by a conventional Rh catalyst, and the metal has been reduced in a stoichiometric or reducing atmosphere to accelerate the desorption of O₂ at lower temperatures than the O₂ desorption temperature in the oxidative atmosphere. The purification of NO can be performed in an oxidative atmosphere even at a low temperature of around 450°C since the O₂ desorption temperature is decreased by using an FeAu alloy as an active spot. NO is considered to be able to be purified at further lower temperatures than that in the oxidative atmosphere by the presence of a reducing agent since a reduction temperature is lowered with FeAu similarly to the O₂ desorption temperature.

In the catalyst for purification of NO_{X} according to the present invention, Au and Fe atoms preferably exist in the state of being close in a solid such as nanoparticles or a thin film, as described above. Therefore, other metal atoms which can be alloyed with both atoms may be included in the part in which both atoms are close whereas an inactive substance such as a carrier material which cannot be alloyed with both atoms may be included only in the range in which it is ensured that both atoms can be in the state of being close.
Thus, when it is necessary to use a carrier, the catalyst for purification NO_{X} according to the present invention may be obtained, for example, by obtaining nanoparticles in which both metals are close with the nanoparticles of a material composing the carrier as nuclei or by layering and thinning Au and Fe atoms on a carrier substrate.
The above-described other metal atoms which can be alloyed with both atoms of Au and Fe atoms may include, for example, W (tungsten) which can improve the thermal resistance of Au by the alloying.
In addition, such carrier materials as described above may include Al₂O₃ (alumina), ZrO₂ (zirconia), CeO₂ (ceria), TiO₂ (titania), and silicon carbide.

When the catalyst for purification of NO_{X} according to the present invention is a thin film, the outermost layer may be any of Figures 1 (1), (2) and (3), and, for example, the outermost layer may be any of the thin layers of Fe and Au as illustrated in Figure 1 (2) and may preferably be the thin layer of Fe. In the case of the embodiment of Figure 1 (2), the catalyst for purification of NO_{X} according to the present invention may be, for example, a thin film in which the outermost layer is an Fe thin layer of 0.25-10 nm, particularly 1-5 nm, and the innermost layer is a Au thin layer of 10-50 nm or a thin film composed of the outermost layer that is a Au thin layer of 0.25-10 nm, particularly 1-5 nm, and the innermost layer that is an Fe thin layer of around 10-100 nm.
In the thin film, the composition of both elements in the outermost layer can be changed by changing the amount of deposited Fe, oxidative and reducing atmospheres, a heating temperature, and heating time.

In the catalyst for purification of NO_{X}, such as a thin-film-shaped catalyst, Au and Fe can preferably be alloyed by heating.
The heating can be performed by heating a deposit to a temperature of 450°C or less, for example, to 350-450°C, for example, with an infrared laser.
The heating may also be a radiation heating method or electron beam heating. In addition, a sample support on which the deposit is put in the heating is preferably one that has a history of being thoroughly heated and, for example, desirably one that does not release a highly reactive gas by the heating.

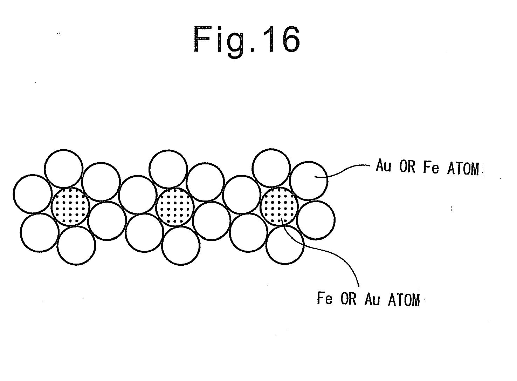

The catalyst for purification of NO_{X} according to the present invention includes a solid in which Fe or Au preferably has a concentration of 0.2-99.8 atm% based on the total of both elements and their atomic ratio is particularly preferably of 1/13 to 12/13.
In addition, the catalyst for purification of NO_{X} according to the present invention preferably includes the solid which is primary particles or a thin film containing Au and Fe as main components as illustrated in Figure 16 and has a surface in which the surface concentration of Fe or Au is 1/7 to 6/7 by atomic ratio based on the total amount of both elements.

In accordance with the catalyst for purification of NO_{X} according to the present invention, it is not necessary to increase a heating temperature for increasing NO_{X} purification activity, for example, a heating temperature by a heater to such a high temperature as in the conventional case, and use of fuel for making an atmosphere in a reduced state becomes unnecessary or can considerably be decreased since it has NO_{X} purification activity even in an oxidative atmosphere.
In addition, in accordance with the catalyst for purification of NO_{X} according to the present invention, it is not necessary to lower an air-fuel ratio (A/F) in an engine and, for example, a high air-fuel ratio (A/F), e.g., A/F of more than 14.7, e.g., A/F ≥ 20, in the case of a gasoline engine and A/F ≥ 30 in the case of a diesel engine can theoretically be enabled during a steady operation.

### Examples

Examples of the present invention will be described below.
In each Example below, the evaluations of an obtained catalyst were performed by measurement methods described below.
1. Measurement of O₂ Desorption Temperature and N₂ Desorption Temperature
   Measurement Method: Measurement of peak intensity by AES (Auger Electron Spectroscopy) at varied heating temperatures
   Measuring Apparatus: KITANO SEIKI KCMA2002
2. Measurement of Temperature of Dissociative Adsorption of NO
   Measurement Method: Measurement of XPS (X-ray photoelectron spectroscopy) spectra at varied heating temperature
   Measuring Apparatus: φESCA1600

3. Measurement of Surface Elemental Composition Ratio of Catalyst
   Measurement Method: Measurement of Au:Fe composition ratio by AES (Auger Electron Spectroscopy)
   Measuring Apparatus: KITANO SEIKI KCMA2002
4. Measurement of Alloying of Catalyst
   Measurement Method: Measurement of Composition of Whole Bulk by XRD (X-Ray Diffraction)
   Measuring Apparatus: PHILIPS X'Pert MRD
5. Measurement of Surface State of Catalyst
   Measurement Method: Measurement of secondary electron image by SEM
   SEM Measuring Apparatus: ZEISS ULTRA55

### Example 1

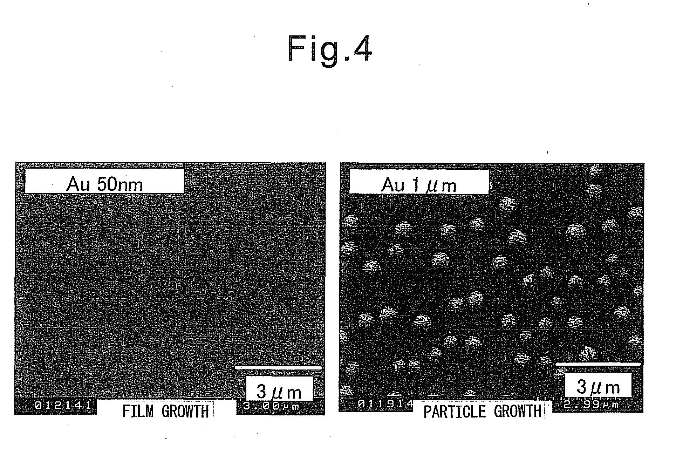

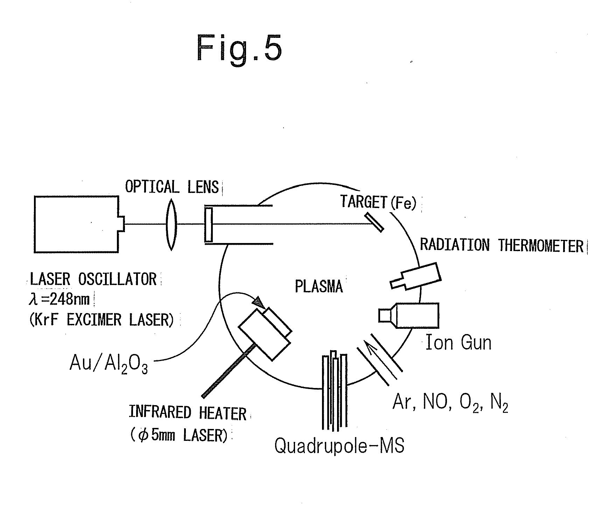

Au and then Fe were deposited on an Al₂O₃ (sapphire) substrate to form a thin film and to prepare a catalyst for purification of NO_{X} in each step as described below. Then, the thin film was heat-treated.
1) A Au-sputtered film was made on the Al₂O₃ (sapphire) substrate by ion sputtering (HITACH E101 Energy 100eV, Ion Current 15 mA). The homogeneous Au film with a thickness of about 30 nm was deposited by performing the sputtering for 2 minutes x 5 times (10 minutes in total). The secondary electron images of the surface after the deposition of Au by AES are illustrated in Figure 4.
2) The deposit is transported into the vacuum chamber of the PLD (Pulsed Laser Deposition) apparatus [including analyzing measures: Auger electron spectroscopy (AES) and X-ray photoelectron spectroscopy (XPS)] having a mechanism as illustrated in the schematic view in Figure 5.
   Ideally, the PLD and the analyzing measures are in-situ. However, it is not necessary to be in-situ and it may be exposed temporarily to the atmosphere and transported if pretreatment as described below can be performed just before analysis.
3) Surface pretreatment is performed by Ar sputtering on the conditions of 0.5 eV, Cham. Pre., and 1.8 x 10⁻⁴ Torr for 30 minutes and twice repeating the conditions of 450°C and 25 minutes as annealing.

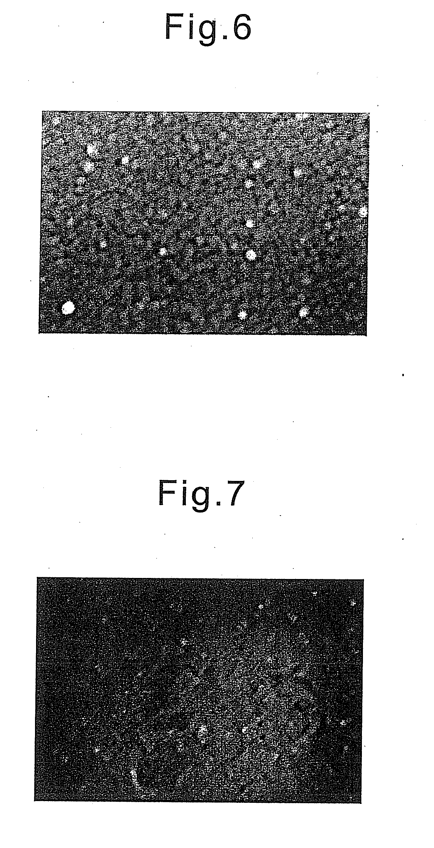

4) As illustrated in Figure 5, an excimer laser (LAMBDA PHYSIC, 25-29 kV, 1-10 Hz, KrF 3000 mbar) is incident into the chamber and hit on the Fe target to deposit a second constituent (Fe) until it is 100% by surface composition. The secondary electron image of the surface after the deposition of Fe by AES is illustrated in Figure 6. A deposition amount is confirmed by AES (PHI).
Figure 6 illustrates that Fe particles were deposited on Au of 50 nm.
5) The deposit is heated to 350°C and alloyed by an infrared laser. The surface after the heating is illustrated in Figure 7.
   For the heating, the sample support on which the deposit was put and which had a history of being thoroughly heated and did not release a highly reactive gas by heating was used.
   The surface composition after the heating by AES was about 40:60 (Fe:Au, atomic ratio).

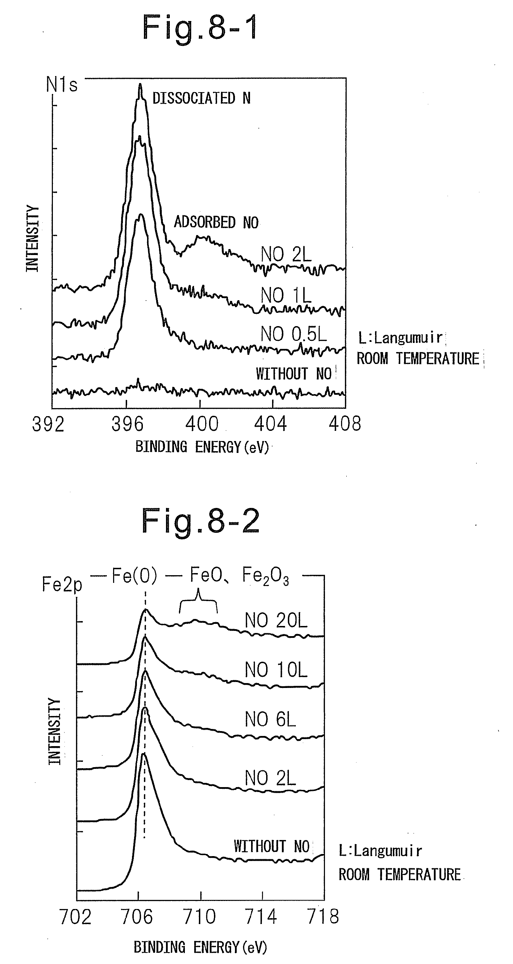

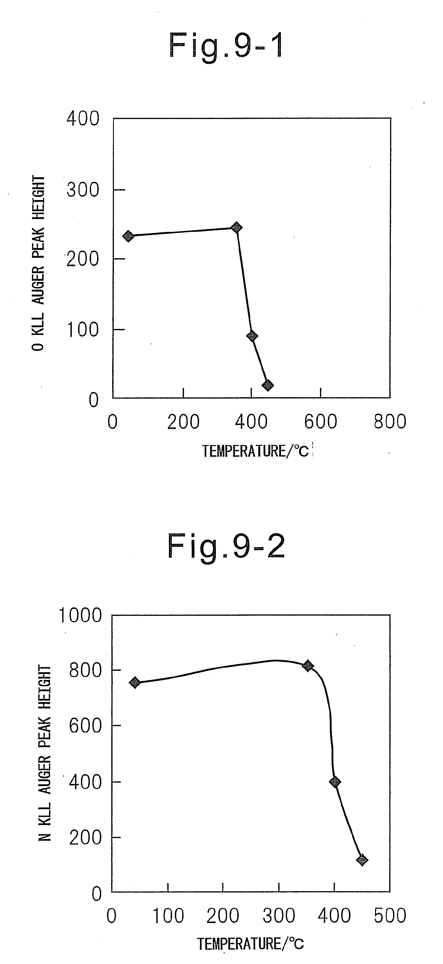

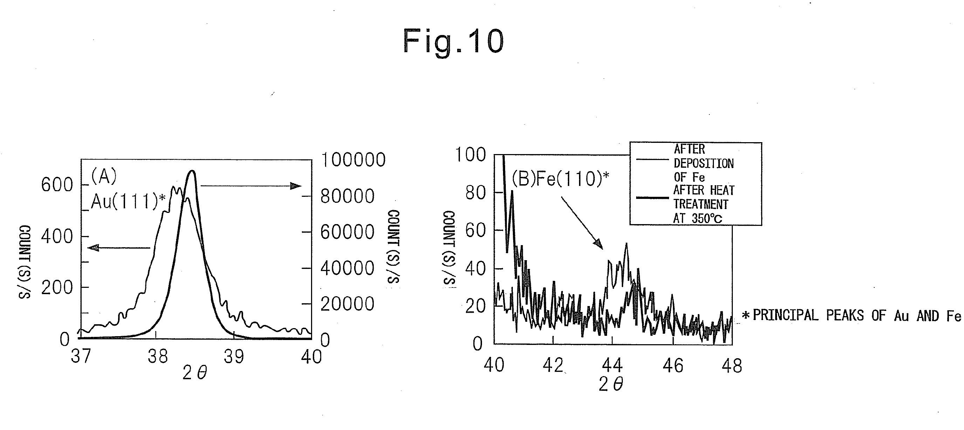

Subsequently, the obtained catalyst was evaluated in the following steps.
6) A NO gas amount of about 1-10 Langmuir (5.0 x 10⁻⁶ Pa, 44s/1 Langmuir at room temperature) is introduced into the chamber to make the catalyst adsorb the NO gas.
7) The peaks of N1s, O1s, Fe2p, Au4f, and the like are observed with XPS (Φ ESCA1600, Monochlo Al-Ka (1486.7 eV), 350 W, 14.0 kV) to analyze dissociative adsorption characteristics by XPS. The results are indicated in Figure 8-1 and Figure 8-2. As indicated in these Figure 8-1 and Figure 8-2, by an energy peak position, a NO-adsorbed state can be distinguished from a N/O dissociative state and it can be judged whether a reaction site is on Fe.
   Figure 8-1 indicates that the dissociative adsorption of NO occurs on Fe at a room temperature.
   It was found from Figure 8-2 that the occurrence of the oxide peaks exhibited the adsorption of O on Fe.
8) The catalyst sample is heated by increasing its temperature by 50°C with the infrared laser to observe variations in N and O peaks with AES (PHI, Energy 1.5 kV, Fil. Cur. 1.9 A, Emi. Cur. 0.9 mA). The measurement results are indicated in Figure 9-1 and Figure 9-2. The temperatures at which the peaks decrease are considered to be desorption temperatures.
   Figure 9-1 indicates that the O₂ desorption temperature is about 450°C.
   Figure 9-2 indicates that the N₂ desorption temperature is about 450°C.
   Furthermore, the results of the XRD measurement of the deposit after the deposition of Fe and the deposit after the heat treatment at 350°C are indicated in Figure 10.

### Comparative Example 1

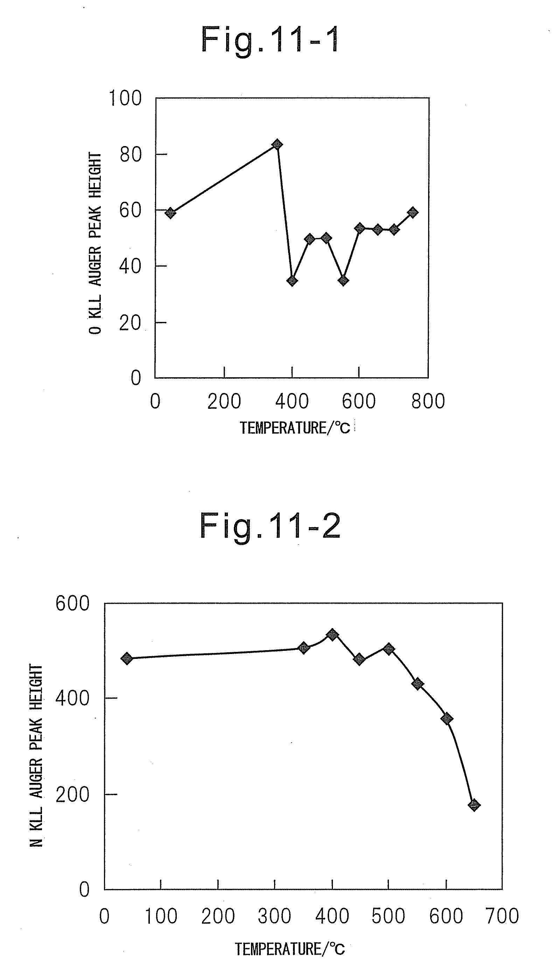

Only Fe was deposited on an Al₂O₃ (sapphire) substrate using the PLD as illustrated in Figure 5 in the same manner as in Example 1 until a surface Fe concentration was 100%.
For the obtained deposit sample, the catalyst sample was heated by increasing its temperature by 50°C with the infrared laser in the same manner as in the step 8) in Example 1 to observe variations in N and O peaks with AES. The measurement results are indicated in Figure 11-1 and Figure 11-2.
Figure 11-1 indicates that the O₂ desorption temperature is about 800°C or more.
Figure 11-2 indicates that the N₂ desorption temperature is about 650°C.

### Comparative Example 2

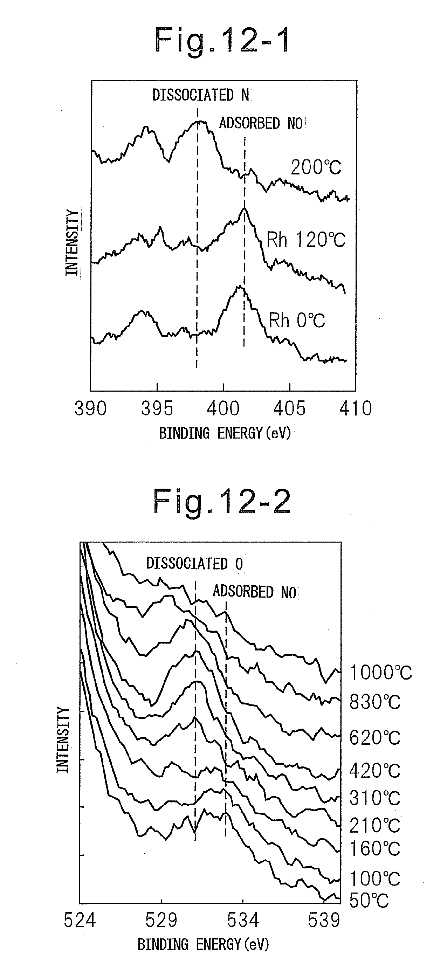

For Rh single crystals, a NO gas amount was introduced into the chamber to make Rh adsorb the NO gas and N1s XPS spectra and O1s XPS spectra were measured with XPS to analyze dissociative adsorption characteristics by XPS, in the same manner as in the steps 6) and 7) in Example 1. The measurement results are indicated in Figure 12-1 and Figure 12-2.
Figure 12-1 indicates that NO was not dissociated on Rh at a room temperature and a dissociation temperature was 100°C or more.
Figure 12-2 indicates that adsorbed NO is observed at 160°C or less but dissociated O is observed with increasing the temperature and O₂ is desorbed at more than 800°C.

### Comparative Example 3

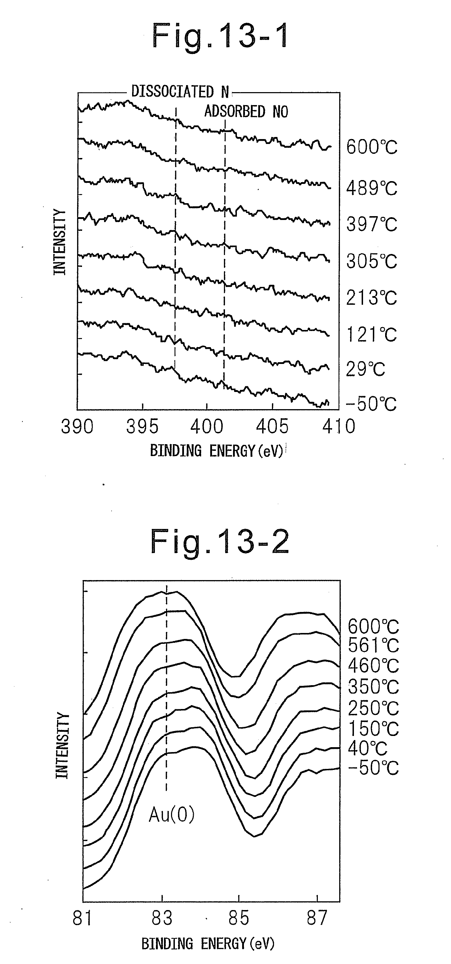

For Au single crystals, a NO gas amount was introduced into the chamber to make Rh adsorb the NO gas and N1s XPS spectra and Au4f XPS spectra were measured with XPS to analyze dissociative adsorption characteristics by XPS, in the same manner as in the steps 6) and 7) in Example 1. The measurement results are indicated in Figure 13-1 and Figure 13-2.
Figure 13-1 and Figure 13-2 indicate that neither NO nor O₂ is adsorbed on Au at -50°C or more.

### Comparative Example 4

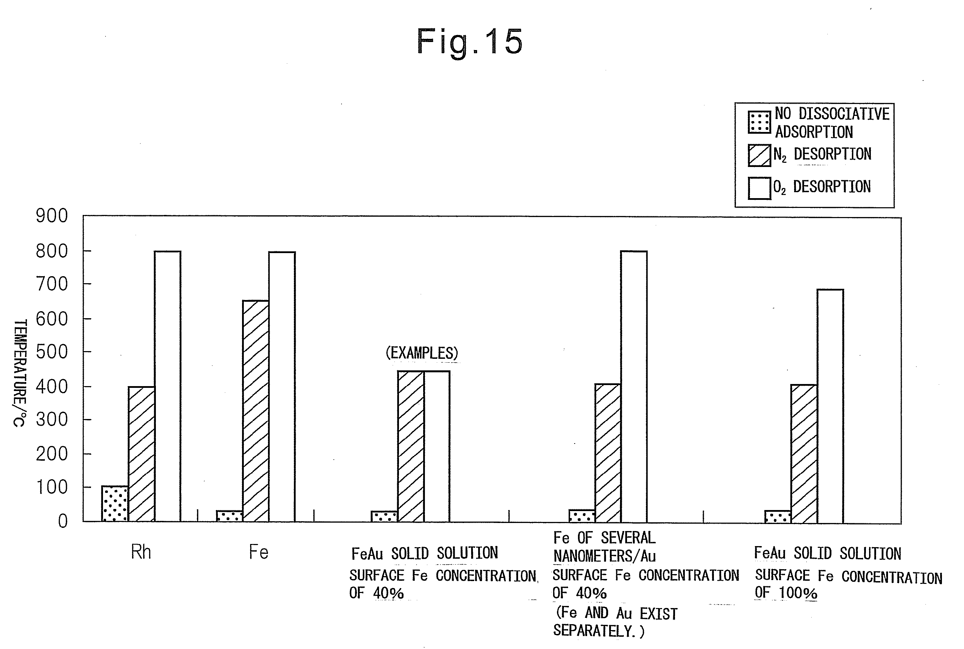

Au and Fe were deposited on an Al₂O₃ substrate so that they existed at a distance not to be close. When the concentrations of both elements in the surface of the obtained deposit in which Au and Fe separately existed were measured by AES, the surface Fe concentration was 40 atm.%.
The NO decomposition and desorption characteristics of the deposit after the heat treatment were evaluated. The measurement results are indicated in Figure 15.

### Example 2

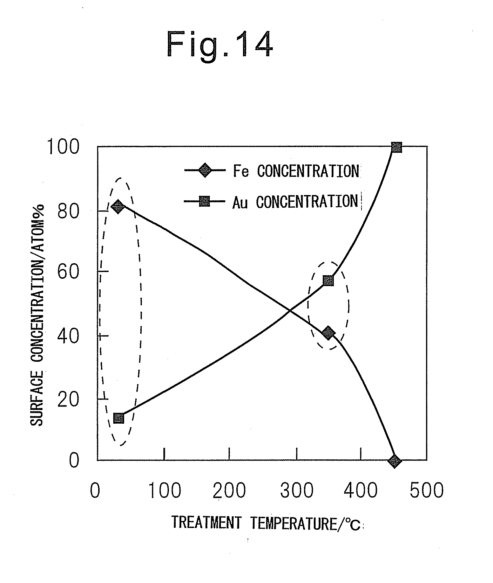

A layered thin film with Fe of several nanometers/Au of 50 nm was formed on an Al₂O₃ substrate in the same manner as in Example 1.
The obtained deposit was heat-treated at varied temperatures.
The heating temperatures and the concentrations of both elements in a surface were measured by AES. The relationships between the heat treatment temperatures and the surface concentrations of Au/Fe are indicated in Figure 14.

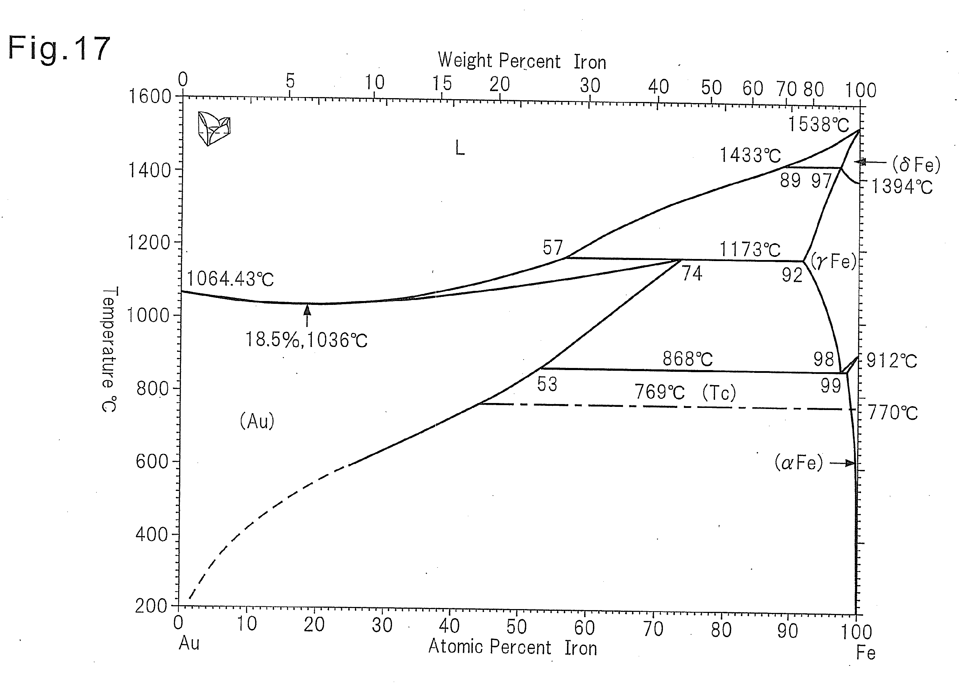

It is understood from Figure 14 that metal surface concentrations (Au/Fe) on the Al₂O₃ substrate can be changed by varying the heat treatment temperatures. Figure 10 as described above indicates that the Au (111) peak shifted to the higher angle side and the Fe (110) peak was reduced by the heat treatment. This suggests that Fe was scattered in Au to shorten the interatomic distance of Au. It is considered from these Figure 7, Figure 10, Figure 14, and the phase diagram of Figure 17 that AuFe is made into a solid solution by heat treatment to form the solid solution.

The NO decomposition and desorption characteristics of the heat-treated catalyst in Example 2 (surface concentration of Fe: 40 atm.%), the catalyst after the deposition of Fe in Example 2 (surface concentration of Fe: 100 atm.%), and the catalysts prepared by heat-treating the deposits in which Fe exists in Comparative Example 1, Rh exists in Comparative Example 2, and Fe and Au separately exist in Comparative Example 4 were evaluated. The results are summarized in Figure 3 and Figure 15.
It is clear from Figure 15 that, when Fe and Au separately exist, only the characteristics of each are exhibited even by heat treatment after the dissociative adsorption of NO.
In addition, when Fe and Au exist to be close in the solid composed of the layered thin film, the temperature of the dissociative adsorption of O₂ is decreased to about 700°C even if the surface contains Fe of 100%, so that the above-described advantage offered by the present invention is observed.

### Industrial Applicability

In accordance with the catalyst for purification of NO_{X} according to the present invention, Au of which at least a part can be calculated in Japan and Fe which exists on the Earth in a large quantity can be used from the viewpoint of exhaustion of resources, it is not necessary to increase a heating temperature for increasing NO_{X} purification activity to such a high temperature as in the conventional case, use of fuel for making an atmosphere in a reduced state become unnecessary or the purification of NO_{X} is enabled from at least low temperatures since it has NO_{X} purification activity even in an oxidative atmosphere, it is not necessary to make an air-fuel ratio (A/F) in an engine in a steady state approximately stoichiometric (A/F = 14.7), and an operation at a high air-fuel ratio (A/F), e.g., A/F = 20, in the case of a gasoline engine and A/F = 30 in the case of a diesel engine can theoretically be enabled.

## Claims

1. A catalyst for purification of a nitrogen oxide, the catalyst comprising a solid in which Au and Fe atoms exist in a state of being close.

2. The catalyst according to claim 1, comprising the Au and Fe atoms, at least one of first atoms in contact with second atoms of the Au and Fe atoms being in a state of being close in a state of existing in nanoparticles which are primary particles or in a thin film.

3. The catalyst according to claim 1, wherein the solid is primary particles or a thin film containing Au and Fe as main components; and Fe or Au in the solid has a concentration of 0.2-99.8 atm% based on the total amount of both elements.

4. The catalyst according to claim 1, wherein the solid is primary particles or a thin film containing Au and Fe as main components and has a surface in which the surface concentration of Fe or Au is 1/7 to 6/7 by atomic ratio based on the total amount of both elements.
